(19) Europäisches Patentamt
European Patent Office
Office européen des brevets

(11) **EP 2 921 883 A1**

(12) **EUROPEAN PATENT APPLICATION**
published in accordance with Art. 153(4) EPC

(43) Date of publication:
**23.09.2015 Bulletin 2015/39**

(51) Int Cl.:
***G01T 3/08*** *(2006.01)*

(21) Application number: **13855174.2**

(22) Date of filing: **11.11.2013**

(86) International application number:
**PCT/ES2013/070778**

(87) International publication number:
**WO 2014/076337 (22.05.2014 Gazette 2014/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **16.11.2012 ES 201231769**

(71) Applicant: **Consejo Superior De Investigaciones Científicas (CSIC)
28006 Madrid (ES)**

(72) Inventors:
• **GUARDIOLA SALMERÓN, Consuelo
E-08193 Bellaterra (Barcelona) (ES)**

• **LOZANO FANTOBA, Manuel
E-08193 Bellaterra (Barcelona) (ES)**
• **FLETA CORRAL, Celeste
E-08193 Bellaterra (Barcelona) (ES)**
• **PELLEGRINI, Giulio
E-08193 Bellaterra (Barcelona) (ES)**
• **QUIRION, David
E-08193 Bellaterra (Barcelona) (ES)**

(74) Representative: **Pons Ariño, Angel
Pons Patentes y Marcas Internacional, S.L.
Glorieta Rubén Dario 4
28010 Madrid (ES)**

(54) **LIQUID-SEMICONDUCTOR NEUTRON DETECTOR**

(57)    The invention relates to a liquid-semiconductor neutron detector characterised in that it comprises a hybrid structure consisting of a solid phase and a liquid phase, where the solid phase comprises a substrate of a semiconductor material characterised in that it has a series of grooves along the surface of one of the faces thereof forming an electrode of the detector, and where the liquid phase is contained in said grooves and characterised in that it comprises at least one neutron converter compound containing at least one isotope that is able to capture neutrons and replace them with charged particles suitable for ionising the semiconductor material. The invention also relates to the method for producing said detector and to the use thereof.

FIG. 2

**Description**

**Technical field of the invention**

The present invention relates to a new concept to create a high-efficiency neutron detector (>50%) combining two technologies which bring together two states of matter (solid and liquid), through MEMS (Micro-Electro Mechanical Systems) technology of manufacturing semiconductor radiation detectors and of microfluidics. The resulting detector is a hybrid of semiconductor and liquid. The main application is the creation of high-efficiency neutron detectors for nuclear medicine and microdosimetry, space exploration, industrial analysis and nuclear security, among others.

**Background of the invention**

Radiation is the form of propagation of energy by means of electromagnetic waves (x-rays, gamma rays, etc.) subatomic particles (protons, neutrons, $\alpha$ particles, electrons, etc.) in movement. Radiation is called "ionising" or "non-ionising" depending on its capacity to pull electrons or not from the medium through which it propagates. This characteristic depends on the intrinsic nature of the particle (i.e. if it is a hadron, a lepton, a photon, a nucleus, etc.), of the type of interaction with the medium (weak, strong or electromagnetic), as well as the initial energy of the particle. Ionising radiations are those particles with electrical charge (electrons, protons, alpha particles, etc.), and X and gamma rays. Neutral particles are not (neutrons, neutral mesons, and a certain type of electromagnetic waves such as microwave, radio waves, etc.).

Most charged particles, such as photons, form part of ionising radiations, which makes it possible to detect them thanks to the ionisation they produce when they pass through matter. If the target on which they interact is composed of a suitable material, and this is conveniently integrated in an electronic reading system, said device shall act as a particle detector. Said targets can be found in solid, liquid or gaseous state, depending on particle type to identify and on the application. Traditionally, the materials used for it have been semiconductors, scintillators and light gases, respectively. Thus, a radiation detector is a device that is able to identify the presence of particles, whether they are of natural origin (cosmic radiation or from primitive disintegration chains) or artificial (provoked nuclear disintegrations, or particles generated in particle accelerators). In this way, for example, in a semiconductor device, when a charged particle or photon pass through it, the ionisation produced in their passage generates electron-hole pairs (charge carriers), so that if we apply an electric field they shall derive towards the electrodes, generating a current pulse in their collection. Through this electrical pulse, the energy deposited by the incident particle (via an external circuit coupled to a reading electronics) can be inferred. However, when a neutral particle, such as a neutron, passes through the medium, there is no direct detection, since they do not have a charge which ionises said matter.

The interest in the detection of neutrons with active sensors has considerably increased in recent years. In this field, two types of detectors have been mainly used: $^3$He gas detectors and scintillators based on $^6$Li. However, both types of detectors share some undesirable characteristics: for example, the $^3$He detectors are heavy and require expensive operating conditions (high pressures, in the order of 10 bar and voltages around 10 kV), and the scintillators need to be connected to a heavy photomultiplier which work at hundreds of volts and require a hermetic packaging due to the hygroscopic nature of said scintillating crystals. Furthermore both types of detectors have relatively high reading times, so that they do not serve for applications which require a high count rate and, what is more important, they are materials with difficult supply: Both $^3$He and $^6$Li are expensive, it is forecast that the reserves of 3He shall be used up in the coming decades [R.T. Kouzes et al., Nucl. Instr. Meth. A 623 (2010) 1035-1045], and $^6$Li requires special authorisation for its exportation. These impediments do not allow the versatility that some environments require and limit the field of application of said detectors. In contrast, semiconductor detectors (SD) have several characteristics that make them very useful for a large part of the environments where neutrons may be found (nuclear medicine and microdosimetry, space exploration, industrial analysis and nuclear security), such as low molecular weight and size, robustness and low battery consumption, as well as a rapid response and insensitivity to electromagnetic fields [S. M. Sze, Physics of Semiconductor Devices, 2nd Ed., John Wiley & Sons, 1981]. However, the adaptation of a SD to detect neutrons entails certain complexities inherent to neutron physics [G.F. Knoll, Radiation detection and measurements, John Willey and Sons, Inc., New York 2000]. As previously mentioned, since the neutrons do not interact with matter by direct ionisation, they cannot be directly detected by means of a semiconductor (SC). To convert a SD into a neutron detector it is necessary to use a suitable isotope of an element (called "converter") that is able to capture neutrons and eject charged particles (as reaction products of the capture) which do ionise the semiconductor and can therefore be detected. In this way, a semiconductor neutron detector consists of a radiation sensor covered or filled by a converter, or one in which the atoms of the converter form part of the material structure [N. Caruso, J. Phys.: Condensed Matter 22 (2010), doi: 10.1088/0953-8984/22/44/443201; C. Guardiola et al., Journal of Instrumentation 6 (2011), doi: 10.1088/1748-0221/6/11/P11001].

Neutrons can be classified *grosso modo* according to their energy (E) as fast (*E*>1 eV) and slow (*E*<1 eV). The object of this invention is centred on the detection of slow neutrons, although it is also valid for the fast range of neutrons. Converters with high section- effective capture of neutrons are based on compounds containing one of the following: mainly $^6$Li, $^{10}$B, $^{113}$Cd, $^{155}$Gd and $^{157}$Gd; although there are also other possible isotopes of much less natural abundance, low effective section and even noble gases or elements that belong to the group of rare earths, such as, for example: $^3$He, $^{135}$Xe, $^{235}$U, $^{238}$U, $^{232}$Th, $^{23}$Na, $^{56}$Fe, $^{91}$Zr, $^{115}$In, $^{197}$Au, Hf, Co, Sm, Ti, Dy, Er, Eu, Mo, Yb. Converters with compounds containing any of these isotopes are also possible, such as, for example: $B_4C$, $BF_3$, LiF, $H_3BO_3$ and $Mo_2B_5$. The nuclear reactions of the most widely used isotopes that are generated in the neutron capture are specified in Table I.

**Table I. Converter isotopes for neutrons**

| Material | Neutron capture reaction |
|---|---|
| $^{10}$B | $^{10}B + n \rightarrow \alpha(1.47 MeV) + {}^7Li(0.84 MeV) + \gamma(0.48 MeV)$ 94% <br> $^{10}B + n \rightarrow \alpha(1.78 MeV) + {}^7Li(1.01 MeV)$ 6% |
| $^6$Li | $n + {}^6Li \rightarrow {}_1^3H\left(2.72\,MeV\right) + \alpha\left(2.05\,MeV\right)$ |
| $^{113}$Cd | $^{113}Cd + n \rightarrow {}^{114}Cd + \gamma(0.56\ MeV) + e^-$ |
| $^{155}$Gd | $^{155}Gd + n \rightarrow {}^{156}Gd + \gamma(0.09, 0.2, 0.3 MeV...) + e^-$ |
| $^{157}$Gd | $^{117}Gd + n \rightarrow {}^{158}Gd + \gamma(0.08, 0.18, 0.28 MeV ...) + e^-$ |

Neutron detectors based on semiconductors with planar geometry [J. K. Shultis and D.S. McGregor, IEEE Trans. Nucl. Sc., Vol. 53, (3) 2006, 1659-1665] have a lower efficiency compared with other technological solutions, such as detectors with perforations (which overcome the planar geometric conditions by increasing the contact surface between the converter and the semiconductor converter with perforation templates within it). Twenty-five years ago, R.A. Muminov and L.D. Tsvang noted that the detection efficiency of neutrons could achieve up to 40%, and even more, if rectangular channels were distributed along the surface of the SD [R.A. Muminov and L.D. Tsvang, At. Energy, vol. 62, No. 4, 265-267, 1987]. However, since they there have been few research groups that have been capable of manufacturing said microstructures in SD for neutron detection. In particular, the group headed by Dr. D.S. McGregor has worked intensely on this subject using $^6$LiF as converter with considerable improvements during recent years, reporting on detection efficiencies for thermal neutrons of 12% for sensors with sinusoidal trenches [D.S. McGregor et al., Nuclear Instruments And Methods in Physics Research A 608 (2009), 125-131] and up to 42% when two detectors are coupled based on perforated structures [S.L. Bellinger et al., IEEE Trans. Nucl. Sci. 59, (1) 2012, 167-173, doi:10.1109/TNS.2011.2175749]. This last research group has at least two patents on perforated semiconductor detectors, but the entire device as a whole is "solid" [D.S. McGregor and R. Klann, US 7164138; D.S. McGregor et al., US 7855372]. There is another patent with similarities, reported by H.C. Climent [H.C. Climent, US 2012/0132819]. However, during years it has been suggested that the efficiency of said devices could achieve up to 50%, a fact which shows that this problem remains incompletely resolved and that it is necessary to propose new prototypes which involve substantial improvements. Recently, C. Guardiola et al. [Journal of Instrumentation, doi:10.1088/1748-0221/7/06/T06003] have presented a study reporting the optimum parameters for one of said perforated structures, but with realistic values in accordance with the current MEMS manufacturing techniques.

The detector object of the present invention achieves, and even exceeds, said expectations. Starting from the idea of Muminov and Tsvang of incorporating perforations or grooves within the semiconductor, a new concept of detector: if said grooves are filled with liquid compounds synthesised with any of the aforementioned isotopes-converters, the reaction products of the neutron capture may easily reach the SD and be detected. In addition, the liquids allow -given the control capacity over their own synthesis- greater possibilities of combination of design parameters for its coupling to the SD. In other words, the object of the present invention is an innovative concept in particle detector physics: a neutron hybrid detector liquid-semiconductor. The advantages involved in incorporating liquids based on converters are numerous, as explained below, and it also allows a versatility in the designs of the SD that contain them that is very advantageous, reducing certain bonding parameters intrinsic in the traditional use of solid converters which hinder their incorporation in micrometric grooves. Examples of techniques used for this are: deposit, evaporation (Physical Vapor Deposition (PVD) or Chemical Vapor Deposition (CVD)), condensation or simple manual methods [D.S. McGregor et al., op. cit.. Bellinger et al., op, cit.; R.J. Nikolic et al., Proceedings of SPIE, vol. 6013 (2005)]. All these techniques are financially expensive, are still to be improved or are difficult to reproduce and incorporate in an industrial process.

Liquids are a state of aggregation of the matter with characteristics which make them very useful for the detectors object of the present invention. In first place, they have penetration qualities that are highly beneficial for their introduction by microfluidic techniques in the perforated SD. The liquids bind a series of physical principles which, conveniently directed (controlling their synthesis parameters), may be advantageously used for their coupling to the SD with grooves. Said physical properties are capillarity, cohesion, adherence, viscosity and surface tension. Furthermore, given the penetration capacity of the liquids, the following capacities should be underlined: (a) the liquids may penetrate orifices, openings and grooves of micrometric size with greater relative facility than the solid converters, (b) they may remain in large openings, (c) they may be spread in fine layers, even micrometric and (d) they are easily absorbed and/or distributed in the event of discontinuities or irregularities in the receptacle/device containing them. In other words, if the neutron converters are synthesised in liquid state, they would add the advantages of the intrinsic properties of the liquids, providing a more viable, simple and economical form of incorporating them in the semiconductors than those offered until now by solid state converters.

## Brief description of the invention

The invention consists of a new concept of high-efficiency neutron detector. The innovation lies in the combination of a substrate of a semiconductor material with its relevant components (p-n bond, ohmic contact, electrodes, electrical contact) so that it is a detector sensitive to radiation/particles, with grooves along its surface and a neutron converter in liquid state contained therein.

A first object of the invention is, therefore, a liquid-semiconductor neutron detector characterised in that it comprises a hybrid structure consisting of a solid phase and a liquid phase. The solid phase is formed by a substrate of a semiconductor material characterised in that it has a series of grooves along its surface, forming one of the electrodes of the detector. The liquid phase is contained in said grooves and characterised in that it comprises at least one neutron converter compound containing at least one isotope that is able to capture neutrons and replace them with charged particles suitable for ionising the semiconductor material.

Said hybrid detector is viable, conjugating the MEMS technology of semiconductor detectors, microfluidic techniques and basic notions of fluids and rheology, and the chemistry of liquid neutron converters. The latter must be synthesised so that they optimise the neutron detection efficiency of the design. In other words, the synthesis parameters of the liquid-converter (such as density, composition, viscosity, concentration, etc.) must be in such correlation with the design parameters of the substrate-semiconductor (dimensions of the groove geometries) that the neutron detection efficiency is maximum. No bibliographic reference or earlier patent has been found which has proposed or made a similar device.

An additional object of the invention is a process for the manufacturing of said detector, which is characterised in that it comprises:

(a) preparing the solid phase consisting of a substrate of a semiconductor material by means of the engraving of a series of grooves along its surface, forming one of the electrodes of the detector;
(b) introducing the liquid phase comprising at least one neutron converter compound in the grooves of the solid phase.

In a particular embodiment of the invention, the process may comprise an additional stage of confinement of the liquid phase in the grooves of the solid phase by means of encapsulation. Alternatively, in another particular embodiment of the process, this may comprise an initial stage (previous or simultaneous to the stage of preparation of the solid phase) of synthesis of the liquid phase. This stage of preparation of the liquid phase may comprise the dissolution of the neutron converter compound in at least one solvent (preferably selected from diglyme (ether 2-methoxyethyl), THF (tetrahydrofurane), acetonitrile, and dibromoethane) and/or the addition of the neutron converter compound to an adherent matrix (preferably selected from PVC and cyanoacrylate). Finally, an additional object of the invention is the use of the detector to detect neutrons.

## Brief description of the figures

Figure 1. Examples of some of the geometric figures of grooves which may be created in the semiconductor.
Figure 2. Schematic diagram of the overall process.

## Detailed description of the invention

The novelty of the present invention lies in the combination of the solid and liquid states: on the one hand, a semiconductor (which may be of several types, e.g. Si, Ge, SiC, CdTe, CdZnTe, GaAs, $B_4C$, among others) which will act as detector-sensitive and, on the other, the liquid which will act as neutron converter in charged particles to be detected by the semiconductor. The neutron converter compound may be synthesised with any of the isotopes described in the "Background of the invention" section, including $^6$Li, $^{10}$B, $^{113}$Cd, $^{155}$Gd, $^{157}$Gd; $^3$He, $^{135}$Xe, $^{235}$U, $^{238}$U, $^{232}$Th, $^{23}$Na, $^{56}$Fe, $^{91}$Zr, $^{115}$In, $^{197}$Au, Hf, Co, Sm, Ti, Dy, Er, Eu, Mo or Yb. In particular, the converter compound may be selected from a group preferably consisting of $B_4C$, $BF_3$, LiF, $H_3BO_3$, $Mo_2B_5$, $B(OH)_3$, $Na_2[B_{12}H_{12}]$, $C_2B_{10}H_{12}$ and $B_{10}H_{14}$. Said combination enables filling the grooves of the semiconductor, since, in principle, the liquids may penetrate, permeate, flood, be distributed in and adapt to all various geometric forms that are engraved in the semiconductor.

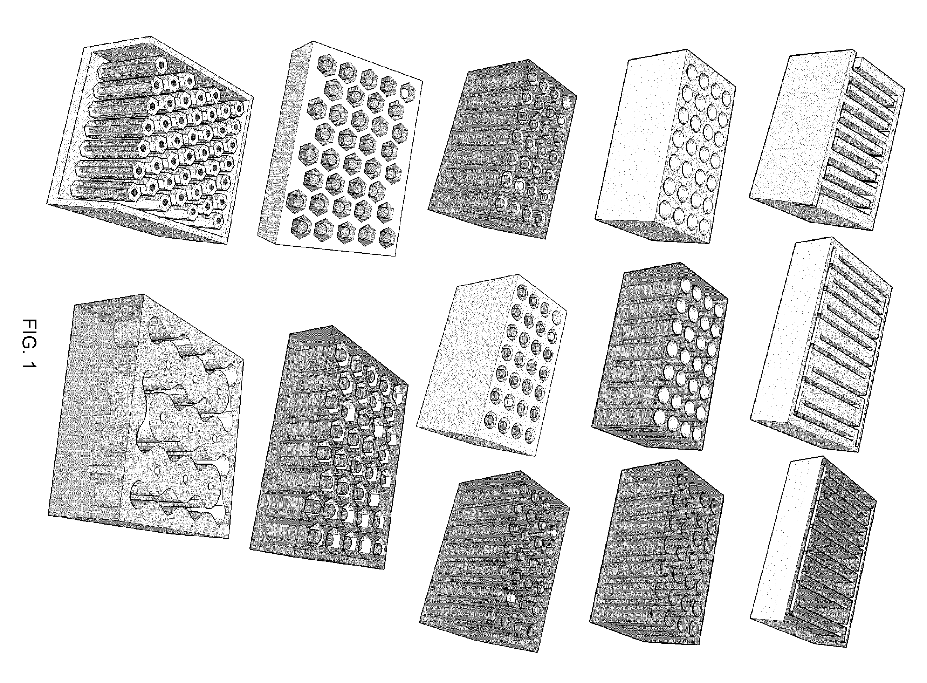

In a particular embodiment of the invention, the manufacturing process of the detector may start with the manufacturing of the solid part of the device. Said process takes place in a cleanroom, wherein the detector of a semiconductor material is manufactured corresponding to the sensitive part or detector of the device. For this, in addition to the semiconductor material, the necessary components are added that give it the capacity to detect radiation/particles, such as, for example, electrodes, insulating layers, contacts, and p-n bonds, among others. To do this, it is possible to make use of standard MEMS manufacturing techniques, creating the previous components by means of doping (ion diffusion or implantation), chemical attack and deposit of layers of materials among others [G. Pellegrini et al., Nuclear Instruments & Methods in Physics Research A (2012), http://dx.doi.org/10.1016/j.nima.2012.05.087]. In this part of the process, a fundamental part is the engraving of the grooves in the semiconductor, which may range from parallel trenches, holes or sinusoidal grooves (some examples are shown in Figure 1). Any other combinations of geometric figures may also arise. It should be stressed that due to basic physical fluid considerations, they facilitation the introduction and later fluidity of the liquids. The grooves constitute in whole or in part one of the electrodes of the detector, although said detector may comprise at least one second electrode. This second electrode may be created on the same face of the detector wherein the grooves have been engraved or on the face opposite them, and it may have planar or three-dimensional geometry (see Figure 1).

In parallel, the liquid converters are synthesised with the optimal parameters according to the semiconductor substrate dimensions, i.e. concentration, density, viscosity, percentages of elements forming the compound, etc., and which have the impact of properties such as adherence, surface tension, cohesion, capillarity, etc., which will make its later coupling to the semiconductor possible. The possibility should be highlighted of combining the manufacturing dimensions of the substrate of semiconductor material, i.e. those referring to the unit cell which forms the base of the selected geometry (trench, hole, coil, etc.), in a fairly accurate manner with the values characteristic of the liquid converter, if both sets of parameters are correlated with, for example, previous Monte Carlo simulations or analytical estimates [C. Guardiola et al., Journal of Instrumentation, doi: 10.1088/1748-0221/7/06/T06003].

Next, the liquid converter is introduced in the solid substrate formed by the semiconductor material, preferably silicon. Depending on the semiconductor material-liquid converter combination, it is possible to use basic microfluidic instrumentation such as micromanipulators, commercial micropipettes or manufactured from borosilicate glass capillaries (being able to use them manually or in mechanised form with joint coupling systems), vacuum pumps, etc. Other possibilities may also be applied for introducing the liquid in the solid substrate formed by the semiconductor material, such as for example: flooding the solid substrate in the liquid converter; simply depositing this on the solid substrate and letting it penetrate naturally or applying a combination of temperature and pressure parameters, e.g. T = 25 °C, P = 30 mbar; immersing the solid substrate in the liquid and applying ultrasounds, for example with a frequency of 24 kHz; using a centrifuge and ovens, etc. Depending on the geometries that have been engraved in the solid substrate and of the attached conductors for the inclusion of the liquid-converter (in addition to generate a flow of initial current according to basic principles of rheology), one or another of the techniques cited shall be more or less practical, exponentially reducing the financial costs and the time with respect to the PVD and CVD techniques commented in the "Background of the invention" section. In general terms, a reduction in costs can be estimated of up to two orders of magnitude and a time reduction in the order of one order of magnitude.

Finally, in a preferred embodiment of the invention, the process may comprise an additional stage of the device together with a material which may be preferably, but not exclusively, PDMS, methacrylate, or glass among others, so that the converter is confined in the grooves of the solid substrate of semiconductor material. There is the possibility that this encapsulation is not essential, in those cases wherein the liquid partially solidifies within the grooves, remaining in a semi-viscous state and adhered to the semiconductor wall.

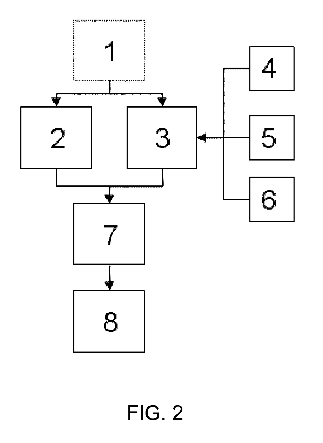

In figure 2, the diagram of the process as a whole is shown in simplified form. In this figure, the following stages are shown:

(1) Pre-calculations (optional) of Monte Carlo simulations or analytical estimates to calculate the parameters of stages (2) and (3);
(2) Manufacturing of the solid substrate formed by a semiconductor material;
(3) Synthesis of the liquid-converter;
(4) Liquid converter;
(5) Liquid converter (4) in solvent;
(6) Liquid converter (4) or liquid converter (4) in solvent (5), in matrix;
(7) Introduction of the liquid-converter in the solid substrate formed by the semiconductor material;

(8) Encapsulation.

The liquid converter in its simplest version is composed of a neutron converter element in liquid phase, e.g. $[C_8mim]_2[B_{12}H_{12}]$ or $[C_8mim]_2[B_{12}H_{12}]$. Boron compounds may also be used which, on being diluted in a suitable solvent, act as liquid converters, such as, for example: $B(OH)_3$, $Na_2[B_{12}H_{12}]$, $C_2B_{10}H_{12}$, $B_{10}H_{14}$, etc. All these compounds may be synthesised with natural boron or enriched in its isotope [10]B. Any other compound which contains boron or any other neutron converter (such as those cited in the "Background of the invention" section) and which may be dissolved can also be used. The solvents that facilitate the introduction of the converter in the grooves may be, for example, among others, diglyme (ether 2-methoxyethyl), THF (tetrahydrofurane), acetonitrile, and dibromoethane. Additionally, the converter may also have an adherent matrix which gives the unit certain adhesion properties to "contain" the converter in a state of aggregation of the transient material (solid-liquid), which allows it to have greater control over the properties thereof. The adherent matrix may be, for example, PVC or cyanoacrylate, among others. Thus, depending on the complexity of the semiconductor design, one or another combination of converter, solvent, and adhesion matrix shall be more or less optimal and functional.

The final state of the converter may be absolutely liquid, such as, for example, the case of $[C_8mim]_2[B_{12}H_{12}]$, or the solvent containing it may evaporate and leave the converter in a state of solid-liquid mesophase within the trenches such as the case of $[B_{12}H_{12}]$ in a PVC matrix and dissolved in THF.

## EXAMPLE

In the example of embodiment, silicon shall be taken as semiconductor material. Therefore, the solid phase of the detector is manufactured with standard MEMS techniques in a cleanroom with high-resistivity silicon wafers, type-n (p> 1 kΩ·cm). In this case, the wafer is processed so that it contains several solid detectors of 0.5 cm2 of active area and, on each one of them, a design of parallel trenches shall be engraved with an Alcatel 601 E along one of the faces of said substrate, like one of the combinations of the cases shown in Figure 1.

For this example, the design has the following parameters for the dimensions of the trenches: height h=250 $\mu$m, length L=5 $\mu$m, width W= 20 $\mu$m. Next, the trenches are coated with a fine layer of polysilicon which is doped with boron (p+) to create the p-n bond. Later, the trenches are passivated with a thin layer of silicon oxide (< 400 nm) and a layer of aluminium (< 500 nm) is deposited to supply the electrical contact for the polarisation and reading electronics. Note that the cavities or grooves are not totally closed, i.e. the openings remain open for the later filling of the liquid converter, and that the layers which coat the trenches must be sufficiently thin to not hinder the passage of the reaction products of the neutrons with the converter. The ohmic contact is performed by means of an implantation of phosphorous (n+) in the rear of the silicon wafer which is later metallised with a layer of aluminium.

In parallel to this process, and in accordance with the previous parameters of the dimensions of the trenches we have engraved on the solid substrate, a liquid-converter of a compound enriched in $^{10}$B with 1.95 grams of $[C_8mim]_2[Bi_2H_{12}]$ dissolved in 4.7 ml of acetonitrile is synthesised, with density=0.94 g/cm$^3$ and molar concentration 0.5 M.

Then, the liquid converter is introduced in the solid substrate. To do this, in this example, in the first trench of the solid substrate (which has been elongated until the edge of the solid substrate) approximately 500 $\mu$l of liquid-converter are deposited with a standard micropipette, and in the last trench (which has also been extended until the other end of the solid substrate) a vacuum extraction pipe is used such that it generates a flow of current that encourages the filling of all the intermediate trenches. The process lasts a few seconds and, on ending, the vacuum extraction is removed, the liquid remains inside the trenches, immersed in the solid substrate, without side spills.

Finally, the device is encapsulated together with a simple PDMS lid-support.

## Claims

1. Liquid-semiconductor neutron detector **characterised in that** it comprises a hybrid structure constituted by a solid phase and a liquid phase where:

    - the solid phase comprises a substrate of a semiconductor material **characterised by** having a series of grooves along the surface of one of the faces thereof forming an electrode of the detector, and
    - the liquid phase is contained in said grooves and **characterised by** comprising at least one neutron converter compound containing at least one isotope that is able to capture neutrons and replace them with charged particles suitable for ionising the semiconductor material.

2. Detector according to claim 1, wherein the isotope is selected from a group consisting of $^6$Li, $^{10}$B, $^{113}$Cd, $^{155}$Gd, $^{157}$Gd; $^3$He, $^{135}$Xe, $^{235}$U, $^{238}$U, $^{232}$Th, $^{23}$Na, $^{56}$Fe, $^{91}$Zr, $^{115}$In, $^{197}$Au, Hf, Co, Sm, Ti, Dy, Er, Eu, Mo and Yb.

3. Detector according to claim either 1 or 2, wherein the converter compound is selected from a group consisting of $B_4C$, $BF_3$, LiF, $H_3BO_3$, $Mo_2B_5$, $B(OH)_3$, $Na_2[B_{12}H_{12}]$, $C_2B_{10}H_{12}$ and $B_{10}H_{14}$.

4. Detector according to any one of claims 1 to 3, wherein the semiconductor material is selected from a group consisting of Si, Ge, SiC, CdTe, CdZnTe, GaAs and $B_4C$.

5. Detector according to any one of claims 1 to 4, comprising at least one second electrode located on the same face or on the face opposite the grooves.

6. Detector according to claim 5, wherein said second electrode has planar or three-dimensional geometry.

7. Process for the manufacturing of a detector according to any one of claims 1 to 6, **characterised in that** it comprises:

   (a) preparing the solid phase consisting of a substrate of a semiconductor material by means of the engraving of a series of grooves along its surface, forming an electrode of the detector, and
   (b) introducing the liquid phase comprising at least one neutron converter compound in the grooves of the solid phase.

8. Process, according to claim 7, **characterised by** further comprising an additional stage of confinement of the liquid phase in the grooves of the solid phase by means of encapsulation.

9. Process, according to claim 7, **characterised by** comprising an initial stage, previous or simultaneous to the stage of preparation of the solid phase, of synthesis of the liquid phase, comprising the dissolution of the neutron converter compound in at least one solvent and/or the addition of the neutron converter compound to an adherent matrix.

10. Process, according to claim 9, wherein said solvent is selected from a group consisting of diglyme(ether 2-methoxyethyl), THF (tetrahydrofurane), acetonitrile, and dibromoethane.

11. Process, according to claim 9, where said adherent matrix is selected from PVC and cyanoacrylate.

12. Use of a detector according to any one of claims 1 to 6, to detect neutrons.

13. Use of a detector according to any one of claims 1 to 6 in nuclear medicine.

FIG. 1

FIG. 2

<div style="text-align:center">

**INTERNATIONAL SEARCH REPORT**

</div>

| | International application No. |
|---|---|
| | PCT/ES2013/070778 |

**A. CLASSIFICATION OF SUBJECT MATTER**

*G01T3/08* (2006.01)

According to International Patent Classification (IPC) or to both national classification and IPC

**B. FIELDS SEARCHED**

Minimum documentation searched (classification system followed by classification symbols)
G01T

Documentation searched other than minimum documentation to the extent that such documents are included in the fields searched

Electronic data base consulted during the international search (name of data base and, where practicable, search terms used)

EPODOC, INVENES, WPI, NPL, INSPEC, XPESP

**C. DOCUMENTS CONSIDERED TO BE RELEVANT**

| Category* | Citation of document, with indication, where appropriate, of the relevant passages | Relevant to claim No. |
|---|---|---|
| Y | WO 2007109535 A2 (UNIV KANSAS STATE ET AL.) 27/09/2007, pág. 7, lin. 6-9; page 33, lines 7 - 16; figure 26a. | 1-13 |
| Y | NAKAMURA et al. Use of liquid helium-3 as a neutron converter for a semiconductor-based neutron detector, Nuclear Instruments and Methods in Physics Research Section A: Accelerators, Spectrometers, Detectors and Associated Equipment, Volume 529, Issues 1–3, 21 August 2004, Pages 399-401, ISSN 0168-9002, http://dx.doi.org/10.1016/j.nima.2004.05.019. | 1-13 |
| A | (BELLINGER ET AL.) Improved High Efficiency Stacked Microstructured Neutron Detectors Backfilled With Nanoparticle LiF, Nuclear Science, IEEE Transactions on , vol.59, no.1, pp.167,173, Feb. 2012. doi: 10.1109/TNS.2011.2175749 | 1-7,12-13 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| 06/02/2014 | **(10/02/2014)** |
| Name and mailing address of the ISA/ <br><br> OFICINA ESPAÑOLA DE PATENTES Y MARCAS <br> Paseo de la Castellana, 75 - 28071 Madrid (España) <br> Facsimile No.: 91 349 53 04 | Authorized officer <br> E. Pina Martínez <br><br><br> Telephone No. 91 3498552 |

Form PCT/ISA/210 (second sheet) (July 2009)

## INTERNATIONAL SEARCH REPORT

Information on patent family members

International application No.

PCT/ES2013/070778

| Patent document cited in the search report | Publication date | Patent family member(s) | Publication date |
|---|---|---|---|
| WO2007109535 A2 | 27.09.2007 | US2009302231 A1<br>US7855372 B2 | 10.12.2009<br>21.12.2010 |
| XP004527326 A | 21.08.2004 | NONE | |
| XP011408684 A | 01.02.2012 | NONE | |

Form PCT/ISA/210 (patent family annex) (July 2009)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7164138 B, D.S. McGregor and R. Klann
- US 7855372 B, D.S. McGregor
- US 20120132819 A, H.C. Climent

**Non-patent literature cited in the description**

- **R.T. KOUZES et al.** *Nucl. Instr. Meth. A,* 2010, vol. 623, 1035-1045
- **S. M. SZE.** Physics of Semiconductor Devices. John Wiley & Sons, 1981
- **G.F. KNOLL.** Radiation detection and measurements. John Willey and Sons, Inc, 2000
- **N. CARUSO.** *J. Phys.: Condensed Matter,* 2010, vol. 22
- **C. GUARDIOLA et al.** *Journal of Instrumentation,* 2011, vol. 6
- **J. K. SHULTIS ; D.S. MCGREGOR.** *IEEE Trans. Nucl. Sc.,* 2006, vol. 53 (3), 1659-1665
- **R.A. MUMINOV ; L.D. TSVANG.** *At. Energy,* 1987, vol. 62 (4), 265-267
- **D.S. MCGREGOR et al.** *Nuclear Instruments And Methods in Physics Research A,* 2009, vol. 608, 125-131
- **S.L. BELLINGER et al.** *IEEE Trans. Nucl. Sci.,* 2012, vol. 59 (1), 167-173
- **C. GUARDIOLA et al.** *Journal of Instrumentation*
- **R.J. NIKOLIC et al.** *Proceedings of SPIE,* 2005, vol. 6013
- **G. PELLEGRINI et al.** *Nuclear Instruments & Methods in Physics Research A,* 2012, http://dx.doi.org/10.1016/j.nima.2012.05.087